# EUROPÄISCHE PATENTSCHRIFT

(11) **EP 0 646 587 B1**
(45) Veröffentlichungstag und Bekanntmachung des Hinweises auf die Patenterteilung: **20.01.1999**
(21) Anmeldenummer: 94810498.9
(22) Anmeldetag: 31.08.1994
(51) Int. Cl.: C07F 9/12, C08G 59/06, C07F 9/655, C08G 59/30, C08G 59/32

(54) **Neue phosphorhaltige Flammschutzmittel für Epoxidharzmassen**
Novel phosphorus-containing flame retardants for epoxy resin compositions
Nouveau produit ignifugé contenant du phosphore pour des compositions de résines époxy

(30) Priorität: 09.09.1993 CH 2702/93
(43) Veröffentlichungstag der Anmeldung: 05.04.1995
(73) Patentinhaber: Ciba Specialty Chemicals Holding Inc., 4057 Basel (CH)
(72) Erfinder: Flury, Dr. Peter, CH-4204 Himmelried (CH); Mayer, Dr. Carl Walter, CH-4125 Riehen (CH); Scharf, Dr. Wolfgang, D-79639 Grenzach-Wyhlen (DE); Vanoli, Dr. Ennio, CH-1723 Marly (CH)

(56) Entgegenhaltungen:
- EP-A- 0 420 811
- EP-A- 0 509 506
- US-A- 3 056 806
- US-A- 4 621 123

## Beschreibung

Die vorliegende Erfindung betrifft neue sterisch gehinderte Organophosphatverbindungen, vorverlängerte Epoxidharze, erhältlich durch Umsetzung dieser Verbindungen mit Polyepoxidverbindungen, und Harzzusammensetzungen auf Basis der Phosphorverbindungen oder der vorverlängerten Epoxidharze.

Die Verwendung von bestimmten halogenarmen, sterisch gehinderten monomeren Phosphaten als Flammschutzmittel für Polymere, z. B. für Epoxidharze, ist bereits in der EP-A-0 456 605 beschrieben. Diese bekannten Verbindungen weisen jedoch keine funktionellen Gruppen auf, die mit den Epoxidharzen reagieren können, so dass sie bei der Härtung nicht in das entstehende Polymernetzwerk eingebaut werden. Bei der Verwendung solcher monomeren Phosphate als Flammhemmer kann man jedoch nicht immer ausschliessen, dass sich die Verbindungen im Laufe der Zeit teilweise aus dem Kunststoffmaterial verflüchtigen, so dass die Flammhemmung des Materials abnimmt und/oder sich andere Eigenschaften des Kunststoffmaterials nachteilig verändern.

Aus der EP-A-0 420 811 sind auch schon vorverlängerte phosphorhaltige Epoxidharze beschrieben, die durch Umsetzung von Dialkylpentaerythritdiphosphiten mit einem Überschuss an Polyepoxidverbindungen erhältlich sind, und nach der Härtung ein unbrennbares oder selbstverlöschendes, halogenfreies Epoxidmaterial mit chemisch gebundenem Phosphor ergeben. Auch dieses Material kann jedoch nicht voll befriedigen. So ist z. B. die Wasseraufnahme des Materials für manche Anwendungen, wie insbesondere für die Herstellung der Laminatbasis gedruckter Schaltungen, noch zu hoch.

Das U.S.-Patent (US-A-)4,621,123 beschreibt weiterhin phosphorhaltige Polyglycidylether von novolackartiger Struktur, deren Härtung flammfestes Epoxidmaterial ergibt.

Das U.S.-Patent (US-A-)3,056,806 beschreibt ferner bestimmte Epoxyalkylester der Phosphorsäure, die sich speziell als Weichmacher und Stabilisator für Vinylharzzusammensetzungen eignen.

Aus der EP-A-0 509 506 sind darüberhinaus kristalline Pulver organischer Diphosphate spezieller Formel bekannt, die sich zur Flammfestmachung, als Antioxidans und Weichmacher für Kunststoffmaterialien eignen.

Die Aufgabe der vorliegenden Erfindung ist es, ein Flammschutzmittel, insbesondere für Epoxidmaterial, zur Verfügung zu stellen, das nach der Härtung chemisch in dem Material gebunden ist und dabei die Forderung nach einer geringen Wasseraufnahme besser befriedigt als herkömmliche Materialien.

Es wurde nun gefunden, dass Verbindungen der Formel (1) 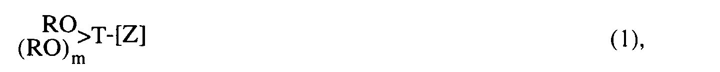 in der
- m: 0 oder 1 ist,
- R: ein Wasserstoffatom oder eine Gruppe der Formel 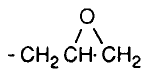 bedeutet,
- T: entweder eine (m+2)-wertige aromatische Gruppe mit 6 bis 14 Ringkohlenstoffatomen oder eine (m+2)-wertige Gruppe darstellt, die sich durch die Entfernung von (m+2) aromatischen Wasserstoffatomen von einer Verbindung der Formel (2) 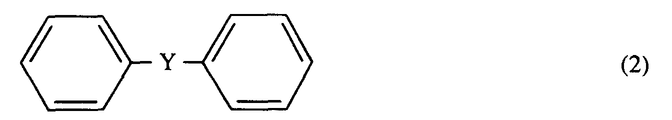 ableitet, in der
- Y: ein chemisches Strukturelement, ausgewählt aus einer Einfachbindung sowie den Gruppen der Formel -O-, -S-, >SO₂, >C=O und 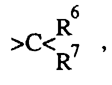 ist, wobei
- R⁶: und
- R⁷: unabhängig voneinander jeweils ein Wasserstoffatom oder eine Methylgruppe darstellen, und
- [Z]: eine Gruppe ist, die aus durchschnittlich 1 bis 10 Struktureinheiten ausgewählt aus Struktureinheiten der Formel (3) besteht

-Q-T(OR)₁₊ₘ₋ᵣ(EB)ᵣ (3),

worin
- Q: eine Gruppe der Formel (4) darstellt 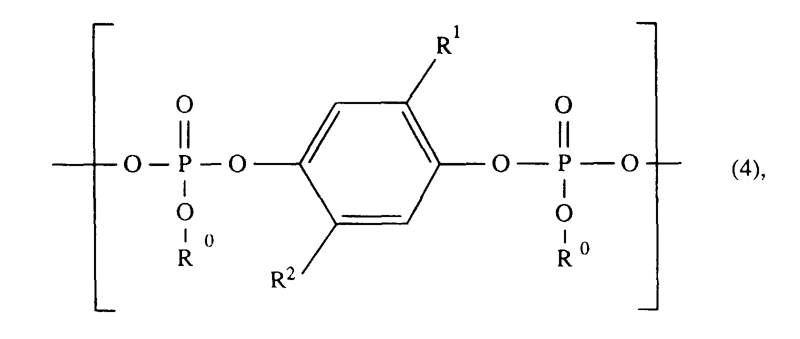 in der
- R⁰: einen Rest der Formel (5) 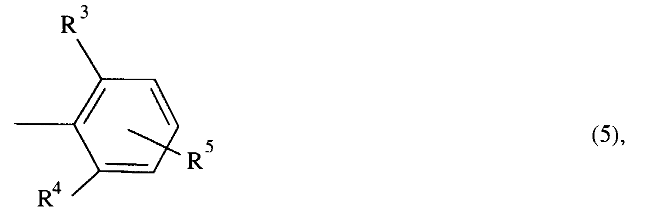
- R¹: und
- R²: und
- R³: unabhängig voneinander jeweils eine C₁-C₄-Alkylgruppe,
- R⁴: ein Wasserstoffatom oder eine C₁-C₄-Alkylgruppe und
- R⁵: ein Wasserstoff-, Brom- oder Chloratom, eine Hydroxylgruppe oder eine GruDDe der Formel 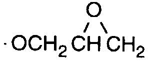 bedeuten,
und in Formel (3) weiterhin
- T: die oben schon genannte Bedeutung hat,
- EB: eine freie Valenz der Gruppe T symbolisiert sowie
- r: einen der Werte 0, 1 oder 1+m aufweist,
wobei die Struktureinheiten der Formel (3) derart und über ihre freien Valenzen zur Gruppe [Z] verknüpft sind, dass sich die Gruppen Q jeweils mit Gruppen T abwechseln und die Gruppe [Z] insgesamt einwertig ist,
sich hervorragend sowohl als flammhemmende Zusatzkomponente zu härtbaren Gemischen auf Basis von Epoxidharzen als auch zur Herstellung von vorverlängerten Epoxidharzen durch Umsetzung mit Polyepoxidverbindungen eignen.

Wenn m gleich 0 ist, stellt [Z] eine Gruppe der Formel

-[Q-T]ₖ-OR

dar, wobei k im allgemeinen einen Wert von 1 bis 10, bevorzugt von 2 bis 5, hat. Ist m dagegen gleich 1, können die Struktureinheiten, aus denen die Gruppe [Z] besteht, sowohl dreiwertig (r gleich 2) als auch zweiwertig (r gleich 1) oder einwertig (r gleich 0) sein, entsprechend den Formeln

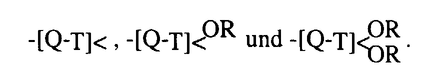

Diese Struktureinheiten können in beliebiger Weise in der Gruppe [Z] kombiniert sein, solange in der oder den sich ergebenden Ketten immer eine Gruppe Q einer Gruppe T folgt (und umgekehrt) und die Gruppe [Z] insgesamt einwertig ist. Dies rührt daher, dass eine Oligomerisierung in den Fällen, wo m gleich 1 ist, beliebig über eine oder mehrere terminale Hydroxylgruppen der Gruppe T erfolgen kann.

Bevorzugt sind Verbindungen der Formel (1), bei denen die Gruppe [Z] aus 2 bis zu etwa 5 wiederkehrenden Struktureinheiten der Formel (3) besteht. Dies ist beispielsweise mit Molekulargewichtsbestimmungen mit Hilfe von Gelpermeationschromatographie feststellbar.

Bei den Resten R¹ und R² der erfindungsgemässen Verbindungen kann es sich generell unabhängig voneinander um jeweils eine Methyl-, Ethyl-, n-Propyl-, i-Propyl-, n-Butyl-, i-Butyl- , sec.-Butyl- oder tert.-Butylgruppe handeln. Bevorzugt handelt es sich bei R¹ und R² jedoch in beiden Fällen um einen Alkylsubstituenten der gleichen Art, insbesondere jeweils um eine tert.-Butylgruppe.

Bei R³ und R⁴ kann es sich ebenfalls unabhängig voneinander um einen der oben genannten Alkylsubstituenten handeln. Bevorzugt als R³ und R⁴ ist Methyl.

R⁵ stellt bevorzugt eine Hydroxylgruppe, eine Gruppe der Formel 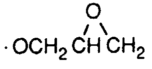 oder besonders bevorzugt ein Wasserstoffatom dar. Halogenreste R⁵ sind weniger bevorzugt, da halogenfreie Verbindungen der Formel (1) die Entsorgung damit hergestellter Kunststoffmaterialien wesentlich erleichtern, und es ist gerade ein grosser Vorteil der erfindungsgemässen Verbindungen, dass mit ihrer Hilfe auf den Einsatz von Halogenverbindungen verzichtet werden kann und dennoch eine vergleichbare Flammschutzwirkung erreicht wird.

Als Gruppe T sind zweiwertige aromatische Ringe mit 6 bis 10 Ringkohlenstoffatomen oder zweiwertige Gruppen der Formel 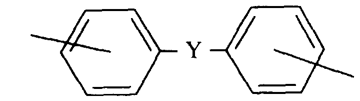 bevorzugt, worin Y eine der oben genannten Bedeutungen hat, insbesondere eine Methylen- oder 2,2-Propylidengruppe darstellt. Besonders bevorzugt als Gruppe T sind 1,3-Phenylen, 1,4-Phenylen, 1,5-Naphthylen und 2,2'-Bis(4-phenylen)-propan, sowie die Gruppe der Formel

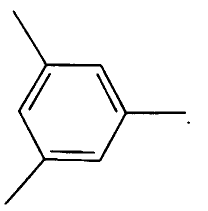

Die erfindungsgemässen Verbindungen sind z. B. auf die folgende Weise erhältlich: Unter inerten Bedingungen setzt man zunächst ein Diphenol der Formel (6) 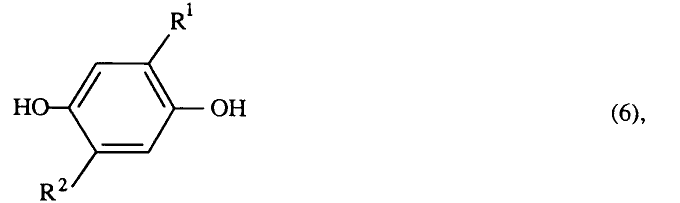 worin R¹ und R² die oben schon angegebene Bedeutung haben,
in einem geeigneten Lösungsmittel mit Phosphortrichlorid um, bevorzugt im ungefähren molaren Verhältnis 1 zu 2 und in Gegenwart einer Base, wie Pyridin oder Triethylamin. Zu diesem Reaktionsgemisch gibt man ebenfalls im ungefähren stöchiometrischen Verhältnis von 2 zu 1, in Bezug auf die eingesetzte Menge des Diphenols der Formel (6), ein Phenol der Formel R⁰OH, worin R⁰ ebenfalls die schon genannte Bedeutung hat, und schliesslich, bevorzugt wieder im ungefähren stöchiometrischen Verhältnis von 2 zu 1, in Bezug auf die eingesetzte Menge des Diphenols der Formel (6), eine Verbindung der Formel T(OH)ₘ₊₂, worin T und m auch die oben schon genannte Bedeutung haben. Das hierbei entstehende Phosphit wird schliesslich in üblicher Weise, z. B. mit Wasserstoffperoxid oder Peressigsäure, oxidiert, wonach das gewünschte Phosphat der Formel (1) als Endprodukt isoliert werden kann.

Bei diesem Herstellungsverfahren kann z. B. durch Variation des stöchiometrischen Verhältnisses der eingesetzten Phenole untereinander die Anzahl der Struktureinheiten der Formel (3), aus denen die Gruppe [Z] im Molekül des Reaktionsprodukts bestehen soll, in gewünschter Weise verändert werden. Beispielsweise führt eine Erhöhung des Anteils des Phenols der Formel T(OH)ₘ₊₂ gegenüber dem Anteil des Phenols der Formel (6) zu einer Erhöhung des Oligomerisierungsgrades der erfindungsgemässen Verbindungen.

Die entsprechenden glycidylisierten Verbindungen können z. B. in bekannter Weise durch Umsetzung der hydroxylterminierten Verbindungen der Formel (1) mit Epichlorhydrin hergestellt werden.

Die erfindungsgemässen Verbindungen können härtbaren Gemischen auf Basis von Epoxidverbindungen als reaktiver Bestandteil zugesetzt werden und auf diese Weise zur Flammfestausrüstung des vernetzten Epoxidmaterials verwendet werden. Hierbei kann die eingesetzte Menge der erfindungsgemässen Verbindungen in weiten Grenzen schwanken, im allgemeinen verwendet man 0,1 bis 100 Gewichtsteile, bezogen auf 100 Gewichtsteile Epoxidharz, bevorzugt 0,5 bis 30 Teile. Die günstigste Menge hängt z. B. von der Natur des Epoxidharzes und von der Art und Anwesenheit anderer Komponenten ab und kann im Einzelfall vom Fachman in einfacher und schneller Weise durch wenige Versuche festgelegt werden.

Als Epoxidharze kommen hierbei praktisch alle bekannten Verbindungen in Frage, die im Durchschnitt mehr als eine 1,2-Epoxidgruppe im Molekül besitzen. Solche Harze können eine aliphatische, aromatische, cycloaliphatische, araliphatische oder heterocyclische Struktur haben; sie enthalten Epoxidgruppen als Seitengruppen, oder diese Gruppen bilden einen Teil eines alicyclischen oder heterocyclischen Ringsystems. Epoxyharze dieser Typen sind allgemein bekannt und im Handel erhältlich. Beispielhaft für Epoxyharze dieses Typs sind zu erwähnen:
I) Polyglycidyl- und Poly-(β-methylglycidyl)-ester erhältlich durch Umsetzung einer Verbindung mit mindestens zwei Carboxylgruppen im Molekül und Epichlorhydrin bzw. Glycerindichlorhydrin bzw. β-Methyl-epichlorhydrin. Die Umsetzung erfolgt zweckmässig in Gegenwart von Basen. Als Verbindungen mit mindestens zwei Carboxylgruppen im Molekül können aliphatische Polycarbonsäuren verwendet werden. Beispiele für diese Polycarbonsäuren sind Glutarsäure, Adipinsäure, Pimelinsäure, Korksäure, Azelainsäure, Sebazinsäure oder dimerisierte bzw. trimerisierte Linolsäure. Es können aber auch cycloaliphatische Polycarbonsäuren eingesetzt werden, wie beispielsweise Tetrahydrophthalsäure, 4-Methyltetrahydrophthalsäure, Hexahydrophthalsäure oder 4-Methylhexahydrophthalsäure. Weiterhin können aromatische Polycarbonsäuren Verwendung finden, wie beispielsweise Phthalsäure, Isophthalsäure, Trimellitsäure oder Pyromellitsäure. Ebenfalls können auch carboxylterminierte Addukte, z.B. von Trimellitsäure und Polyolen, wie beispielsweise Glycerin oder 2,2-Bis-(4-hydroxycyclohexyl)-propan, verwendet werden.
II) Polyglycidyl- oder Poly-(β-methylglycidyl)-ether erhältlich durch Umsetzung einer Verbindung mit mindestens zwei freien alkoholischen Hydroxygruppen und/oder phenolischen Hydroxygruppen und einem geeignet substituierten Epichlorhydrin unter alkalischen Bedingungen, oder in Anwesenheit eines sauren Katalysators und anschliessender Alkalibehandlung. Ether dieses Typs leiten sich beispielsweise ab von acyclischen Alkoholen, wie Ethylenglykol, Diethylenglykol und höheren Poly-(oxyethylen)-glykolen, Propan-1,2-diol, oder Poly-(oxypropylen)-glykolen, Propan-1,3-diol, Butan-1,4-diol, Poly-(oxytetramethylen)-glykolen, Pentan-1,5-diol, Hexan-1,6-diol, Hexan-2,4,6-triol, Glycerin, 1,1,1-Trimethylolpropan, Bistrimethylolpropan, Pentaerythrit, Sorbit, sowie von Polyepichlorhydrinen. Sie leiten sich aber auch beispielsweise ab von cycloaliphatischen Alkoholen, wie 1,3- oder 1,4-Dihydroxycyclohexan, Bis-(4-hydroxycyclohexyl)-methan, 2,2-Bis-(4-hydroxycyclohexyl)-propan oder 1,1-Bis-(hydroxymethyl)-cyclohex-3-en, oder sie besitzen aromatische Kerne, wie N,N-Bis-(2-hydroxyethyl)-anilin oder p,p'-Bis-(2-hydroxyethylamino)-diphenylmethan. Die Epoxidverbindungen können sich auch von einkernigen Phenolen ableiten, wie beispielsweise von Resorcin oder Hydrochinon, oder sie basieren auf mehrkernigen Phenolen, wie beispielsweise auf Bis-(4-hydroxyphenyl)-methan (Bisphenol F), 2,2-Bis-(4-hydroxyphenyl)-propan (Bisphenol A), oder auf unter sauren Bedingungen erhaltenen Kondensationsprodukten von Phenolen oder Kresolen mit Formaldehyd, wie Phenol-Novolake und Kresol-Novolake. Die Epoxidverbindungen dieser Gruppe II sind bevorzugt.
III) Poly-(N-glycidyl)-Verbindungen sind beispielsweise erhältlich durch Dehydrochlorierung der Reaktionsprodukte von Epichlorhydrin mit Aminen, die mindestens zwei Aminwasserstoffatome enthalten. Bei diesen Aminen handelt es sich zum Beispiel um n-Butylamin, Anilin, Toluidin, m-Xylylendiamin, Bis-(4-aminophenyl)-methan oder Bis-(4-methylaminophenyl)-methan. Zu den Poly-(N-glycidyl)-Verbindungen zählen aber auch N,N'-Diglycidylderivate von Cycloalkylenharnstoffen, wie Ethylenharnstoff oder 1,3-Propylenharnstoff, und N,N'-Diglycidylderivate von Hydantoinen, wie von 5,5-Dimethylhydantoin.
IV) Beispiele für Poly-(S-glycidyl)-Verbindungen sind Di-S-glycidylderivate, die sich von Dithiolen, wie beispielsweise Ethan-1,2-dithiol oder Bis-(4-mercaptomethylphenyl)-ether, ableiten.
V) Beispiele für Epoxidverbindungen, worin die Epoxidgruppen einen Teil eines alicyclischen oder heterocyclischen Ringsystems bilden, sind beispielsweise Bis-(2,3-epoxicyclopentyl)-ether, 2,3-Epoxicyclopentylglycidylether, 1,2-Bis-(2,3-epoxicyclopentyloxy)-ethan, Bis-(4-hydroxycyclohexyl)-methandiglycidylether, 2,2-Bis-(4-hydroxycyclohexyl)-propandiglycidylether, 3,4-Epoxycyclohexylmethyl-3,4-epoxycyclohexancarboxylat, 3,4-Epoxy-6-methyl-cyclohexylmethyl-3,4-epoxy-6-methylcyclohexancarboxylat, Di-(3,4-epoxycyclohexylmethyl)hexandioat, Di-(3,4-epoxy-6-methyl-cyclohexylmethyl)hexandioat, Ethylenbis-(3,4-epoxycyclohexancarboxylat), Ethandioldi-(3,4-epoxycyclohexylmethyl)-ether, Vinylcyclohexendioxid, Dicyclopentadiendiepoxid oder 2-(3,4-Epoxycyclohexyl-5,5-spiro-3,4-epoxy)cyclohexan-1,3-dioxan.

Es lassen sich aber auch Epoxidharze verwenden, bei denen die 1,2-Epoxidgruppen an unterschiedliche Heteroatome bzw. funktionelle Gruppen gebunden sind. Zu diesen Verbindungen zählen beispielsweise das N,N,O-Triglycidylderivat des 4-Aminophenols, der Glycidylether-glycidylester der Salicylsäure, N-Glycidyl-N'-(2-glycidyloxypropyl)-5,5-dimethylhydantoin oder 2-Glycidyloxy-1,3-bis-(5,5-dimethyl-1-glycidylhydantoin-3-yl)propan.

Natürlich können auch Mischungen von Epoxidharzen eingesetzt werden, ebenso wie vorverlängerte Epoxidharze, d. h. noch freie Epoxidgruppen aufweisende vorreagierte Addukte eines oder mehrerer Epoxyharze mit einer oder mehreren Verbindungen, die mindestens zwei funktionelle Gruppen pro Molekül enthalten, die mit Epoxidgruppen reagieren. Als Verbindungen, die mit Epoxidgruppen reagieren können, kommen z. B. aliphatische oder aromatische Diamine und Diole in Frage. Diese werden zur Herstellung der vorverlängerten Epoxidharze mit einem Überschuss an Epoxidharzen umgesetzt (Überschuss Epoxidgruppen in Bezug auf die mit Epoxidgruppen reaktiven funktionellen Gruppen). Gegebenenfalls können die so erhaltenen vorverlängerten Epoxidharze auch in der gleichen Weise weiter verlängert werden.

Eine besonders bevorzugte Ausführungsform stellen vorverlängerte Epoxidharze dar, die durch Umsetzung eines Gemisches erhältlich sind, das zumindest eine Verbindung der Formel (1), die freie Hydroxylgruppen aufweist, und mindestens eine Polyepoxidverbindung enthält, bevorzugt einen Glycidylether auf Basis von Bisphenol A oder Bisphenol F oder eines Novolaks, insbesondere eines Phenolformaldehyd- oder eines Kresolformaldehydnovolaks. Diese vorverlängerten Epoxidharze bilden daher ebenfalls einen Gegenstand der vorliegenden Erfindung. Da die erfindungsgemässen vorverlängerten Epoxidharze im allgemeinen fest sind, können sie gegebenenfalls auch in einem geeigneten Lösungsmittel, wie Methylethylketon, gelöst werden. Dies geschieht vorzugsweise unter Erwärmung.

Die Erfindung betrifft auch Zusammensetzungen, die eine Verbindung der Formel (1) zusammen mit einem Epoxidharz enthalten, und Zusammensetzungen, die ein vorverlängertes Epoxidharz auf Basis einer Verbindung der Formel (1) enthalten.

Die erfindungsgemässen Zusammensetzungen können ausserdem weitere übliche Zusätze und Modifizierungsmittel in einer für den jeweiligen Zweck geeigneten Menge enthalten, wie z.B. Hitzestabilisatoren, Lichtstabilisatoren, UV-Absorber, Antioxidantien, antistatische Mittel, Konservierungsmittel, Haftvermittler, Füllstoffe, Pigmente, Schmierstoffe, Verschäumungsmittel, Fungizide, Weichmacher, Verarbeitungshilfsmittel, weitere flammhemmende Zusätze und Mittel zum Verringern der Rauchentwicklung.

Als zusätzliche Flammhemmer, die zusammen mit den erfindungsgemäss verwendeten Verbindungen der Formel I eingesetzt werden können, kommen z.B. phosphorhaltige Salze, wie z.B. Ammoniumpolyphosphate, Aluminiumphosphate, in Frage, ausserdem Aluminiumoxidhydrate, wie Al(OH)₃, ebenso Magnesiumhydroxid, Quarz, Zinkborat oder weitere Phosphorverbindungen, wie z. B. die in der EP-A-0 412 936 beschriebenen Verbindungen, oder tertiäre Phosphinoxide, z. B. die Verbindung der Formel 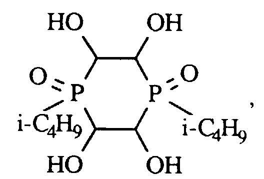 die auch unter der Bezeichnung Cyagard®RF-1204 kommerziell erhältlich ist. Gut geeignet als zusätzlicher Flammhemmer für die erfindungsgemässen Zusammensetzungen ist auch die Verbindung der Formel 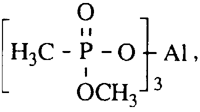 die unter der Bezeichnung REOFLAM®410 kommerziell erhältlich ist. Selbstverständlich können die erfindungsgemässen Verbindungen auch zusammen mit halogenhaltigen Flammhemmern, z. B. mit Tetrabrombisphenol A oder dem davon abgeleiteten Diglycidylether, eingesetzt werden. In manchen Fällen ergeben Kombinationen der erfindungsgemässen Verbindungen, entweder per se oder in Form eines vorverlängerten Epoxidharzes eingesetzt, mit einem oder mehreren anderen, insbesondere halogenfreien Flammschutzmitteln, beispielsweise den oben genannten, besonders gute Eigenschaften.

So enthält eine ganz besonders bevorzugte erfindungsgemässe Zusammensetzung ein vorverlängertes Epoxidharz auf Basis einer der erfindungsgemässen Verbindungen, bevorzugt in einer Menge von 10 bis 40 Gewichtsteilen, und ein weiteres phosphorhaltiges Flammschutzmittel, bevorzugt in einer Menge von 5 bis 40 Gewichtsteilen. Gegebenenfalls kann noch ein wasserunlöslicher, nicht hygroskopischer und gegenüber dem Harz inerter Füllstoff als weitere flammhemmende Komponente enthalten sein, bevorzugt in einer Menge von 20 bis 80 Gewichtsteilen. Bei Verwendung der erfindungsgemässen Verbindungen wird auch bei einem vergleichsweise geringen Gehalt an solchen mit dem Harz nicht reaktiven Füllstoffkomponenten eine ausgezeichnette Flammhemmung (Klasse V-0 gemäss UL 94) ohne Probleme erreicht. Als weiteres phosphorhaltiges Flammschutzmittel für die erfindungsgemässen Zusammensetzungen besonders bevorzugt ist die oben schon erwähnte Verbindung der Formel 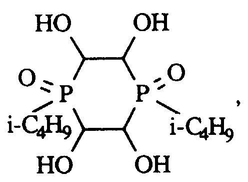 insbesondere zusammen mit Aluminiumtrihydrat. Als Epoxidharze zur Vorverlängerung sind auch bei diesen speziellen Zusammensetzungen Glycidylether auf Basis von Bisphenol A oder Bisphenol F oder von Phenolformaldehyd- und Kresolformaldehydnovolaken besonders bevorzugt.

Die erfindungsgemässen Zusammensetzungen können in bekannter Weise hergestellt werden, beispielsweise durch Vormischen einzelner Komponenten und anschliessendes Vermischen dieser Vormischungen oder durch Vermischen aller Komponenten mittels üblicher Vorrichtungen, wie Rührbehälter oder Dispergator, gegebenenfalls bei leicht erhöhter Temperatur.

Die erfindungsgemässen Zusammensetzungen können je nach den Wünschen des Anwenders als Einkomponenten- oder Zweikomponentengemische konfektioniert sein. Im ersten Fall enthalten sie als einen weiteren Bestandteil einen üblichen, vorzugsweise latenten Härter für Epoxidharze, z. B. Dicyandiamid. Im zweiten Fall bilden sie die Polymerkomponente des Zweikomponentensystems und werden erst kurz vor Gebrauch mit einer einen üblichen Härter für Epoxidharze enthaltenden Komponente gemischt.

Die erfindungsgemässen Zusammensetzungen lassen sich ganz allgemein zur Herstellung gehärteter Produkte einsetzen und eignen sich für alle Anwendungszwecke, wo härtbare Gemische auf Basis von Epoxidharzen in der Technik eingesetzt werden, z. B. als Beschichtungsmassen, Lacke, Pressmassen, Tauchharze, Giessharze, Imprägnierharze, Laminierharze, 1- oder 2-Komponentenklebstoffe oder als Matrixharze, insbesondere zur Umhüllung und Impregnierung von Gegenständen. Ein besonders bevorzugtes Einsatzgebiet ist der Einsatz als Laminierharz zur Herstellung der Laminatbasis gedruckter Schaltungen.

Wenn in den folgenden Beispielen nichts anderes angegeben ist, verstehen sich die Mengenangaben in Gramm.

Beispiel 1: Herstellung der Verbindung 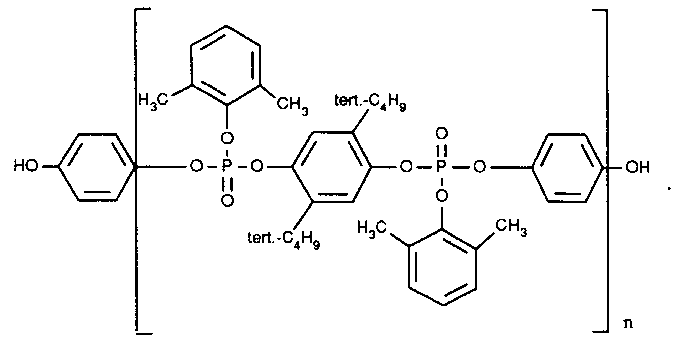 In einem Reaktionsgefäss mit Intensivkühler und Abgaswaschanlage werden unter trockenem Stickstoff und guter Rührung 3,78 kg 2,5-Di-tert.-Butylhydrochinon (17 Mol), 3 kg Essigsäureethylester und 0,170 kg Pyridin vermischt und auf eine Innentemperatur von 60 °C erwärmt. Hierzu werden bei 60 °C während 30 Minuten 4,67 kg Phosphortrichlorid (34 Mol) gegeben. Das erhaltene Gemisch wird ca. eine Stunde lang unter Rückfluss erhitzt (Innentemperatur ca. 74 °C). Dann wird bei einer Innentemperatur im Reaktionsgefäss von 75 - 77 °C während einer Stunde eine Lösung von 4,15 kg 2,6-Dimethylphenol (34 Mol) in 3 kg Essigsäureethylester zugegeben, die entstehende braune Lösung während 1 Stunde und 30 Minuten unter Rückfluss gerührt und danach auf ca. 25 °C abgekühlt. Hierzu werden bei 25 °C während ca. 2 Minuten eine Lösung von 3,74 kg Hydrochinon (34 Mol) in 9 kg Essigsäureethylester und 2,7 kg Aceton und danach 4,66 kg Triethylamin (46 Mol) gegeben und es wird weitere 30 Minuten gerührt. Danach werden 3,86 kg 30%-iges H₂O₂ während ca. 1 Stunde zugegeben, wobei die Temperatur im Reaktionsgefäss zwischen 30 und 35 °C gehalten wird, und es wird weitere 2 Stunden gerührt. Es wird zweimal mit 1N HCl und einmal mit 0,1 N HCl gewaschen, die organische Phase abgetrennt, mit Natriumsulfat getrocknet und unter Vakuum vom Lösungsmittel befreit. Das hierbei erhaltene feste Produkt wird schliesslich noch 30 Minuten unter Hochvakuum weiter getrocknet.

Es werden 8,33 kg des gewünschten Produktes (71% der Theorie) erhalten. Aus dem GPC ergibt sich Mₙ= 700 und M_{w}= 2947. Die Analyse des Produktes lautet wie folgt:

| | C[%] | H[%] | P[%] |
|---|---|---|---|
| gefunden | 64,35 | 6,28 | 8,22 |
| berechnet | 65,28 | 6,00 | 8,02 |

Der Chlorgehalt des Produktes liegt unter 0,3%.

Beispiel 2: Herstellung der Verbindung 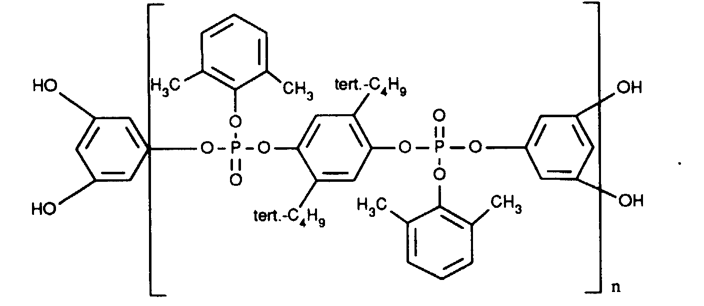 In einem Reaktionsgefäss mit Intensivkühler und Abgaswaschanlage werden unter trockenem Argon und guter Rührung 22,22 g 2,5-Di-tert.-Butylhydrochinon (0,1 Mol), 17,5 g Essigsäureethylester und 1,05 g Pyridin vermischt. Hierzu werden 27,5 g Phosphortrichlorid (0,2 Mol) gegeben. Das erhaltene Gemisch wird langsam erhitzt und während 1 Stunde unter Rückfluss gehalten. Dann wird während ca. 10 Minuten eine Lösung von 24,4 g 2,6-Dimethylphenol (0,2 Mol) in 17,5 g Essigsäureethylester zugegeben, die entstehende braune Lösung während 1 Stunde und 30 Minuten unter Rückfluss gerührt und danach auf Raumtemperatur abgekühlt. Hierzu werden unter Eiskühlung während ca. 15 Minuten eine Lösung von 25,22 g 1,3,5-Trihydroxybenzol (0,2 Mol) in 52 g Essigsäureethylester und 15,5 g Aceton und danach während 30 Minuten und weiterer Eiskühlung 27,35 g Triethylamin (0,27 Mol) gegeben und es wird weitere 30 Minuten gerührt. Danach werden 22,67 g 30%-iges H₂O₂ langsam und unter guter Kühlung zugegeben, und es wird noch einmal 2 Stunden gerührt. Danach wir das gewünschte Produkt entsprechend Beispiel 1 isoliert und getrocknet.

Das erhaltene braune, harzartige Produkt hat einen Erweichungspunkt von 156,6 171,2 °C. Die Analyse des Produktes lautet wie folgt:

| | C[%] | H[%] | P[%] |
|---|---|---|---|
| gefunden | 61,20 | 6,53 | 8,13 |
| berechnet | 62,53 | 6,00 | 7,68 |

Der Hydroxylgehalt des Produktes beträgt 5,65 mÄquiv. OH/g.

Beispiel 3: Aus den in der folgenden Tabelle jeweils angegebenen Komponenten werden die vorverlängerten Epoxidharze 1 bis 4 hergestellt.

| Komponente | Harz 1 | Harz 2 | Harz 3 | Harz 4 |
|---|---|---|---|---|
| Bisphenol-A-diglycidylether¹ | 100,00 | 100,00 | 100,00 | 100,00 |
| Verbindung aus Beispiel 1 | 20,00 | 20,00 | 20,00 | 20,00 |
| Diaminotriazin | - | 4,00 | - | - |
| Diethyltoluoldiamin | - | - | 4,00 | - |
| Diaminodiphenylsulfon | - | - | - | 6,00 |
| o-Cresol-Novolak² | 10,00 | - | - | - |
| Methylethylketon | 32,50 | 31,00 | 31,00 | 31,50 |

| | | | | |
|---|---|---|---|---|
| ¹Epoxidzahl: 5,29-5,41 Äquiv./kg; Viskosität(25°C): 12000-14000 mPa·s | | | | |
| ²Schmelzpunkt 100 °C; Hydroxylzahl: 8,5 Äquiv./kg | | | | |

Zur Herstellung der vorverlängerten Harze wird der Bisphenol-A-diglycidylether auf 100 - 120 °C erwärmt. Danach wird die Verbindung aus Beispiel 1 zugesetzt und das Gemisch bei 170 °C bis zur Konstanz der Epoxidzahl umgesetzt. Anschliessend wird jeweils die weitere Komponente zugesetzt und wieder bis zur Konstanz der Epoxidzahl reagieren lassen. Das noch warme Harz wird danach in der angegebenen Menge Methylethylketon als Lösungsmittel gelöst.

Jeweils unter Verwendung der Harze 1, 2, 3 und 4 werden die Imprägnierlösungen IL1, IL2, IL3 und IL 4, deren weitere Zusammensetzung sich aus der folgenden Tabelle ergibt, hergestellt.

| Komponente* | IL1 | IL2 | IL3 | IL4 |
|---|---|---|---|---|
| Harz: Nr. | 1 | 2 | 3 | 4 |
| Menge | 125,00 | 125,00 | 125,00 | 125,00 |
| Dicyandiamid³ | 36,20 | 35,20 | 40,10 | 37,10 |
| Cyagard^{®}RF 1204 | 20,00 | 20,00 | 20,00 | 20,00 |
| Apyral^{®}4⁴ | 40,00 | - | 40,00 | 40,00 |
| 2-Methylimidazol | 0,08 | - | 0,10 | 0,08 |

| | | | | |
|---|---|---|---|---|
| ³Die Gewichtsangabe bezieht sich auf eine 10%-ige Lösung von Dicyandiamid in Methylglycol | | | | |
| ⁴Aluminiumoxidtrihydrat | | | | |
| *Gewünschtenfalls kann den obigen Imprägnierlösungen noch ein Verlaufsmittel in üblicher Menge zugesetzt werden, ohne dass sich die unten angegebenen Eigenschaften dadurch ändern. | | | | |

Mit Hilfe der Imprägnierlösungen IL1, IL2, IL3 und IL4 werden die Laminate LAM1, LAM2, LAM3 und LAM4 hergestellt. Hierzu wird zunächst Glasgewebe mit der Imprägnierlösung getränkt und das Ganze im Ofen einige Minuten lang bei 170 °C getrocknet. Die resultierende Prepreg wird in passende Stücke zerschnitten. Acht Lagen dieser Prepregs werden zwischen 2 Lagen Kupferfolie gegeben und durch einstündiges Pressen bei 170 °C zum fertigen Laminat verpresst. Die erhaltenen Laminate haben die in der nachfolgenden Tabelle angeführten Eigenschaften.

| Eigenschaft | LAM1 | LAM2 | LAM3 | LAM4 |
|---|---|---|---|---|
| Tg 1⁵ [°C] | 131,5 | 136,5 | 138,7 | 141,2 |
| Tg 2⁵ [°C] | 133,5 | 137,8 | 139,40 | 143,7 |
| NMP-Aufnahme⁶ [%] | 0,24 | -** | 0,08 | 0,08 |
| H₂O-Aufnahme⁷[%] | 0,40 | -** | 0,37 | 0,40 |
| Pct⁸ | bst | -** | bst | bst |
| Flammhemmung⁹ | V-0 | V-0 | V-0 | V-0 |
| Brennzeit [s] | 14 | 42 | 25 | 34 |
| Phosphorgehalt [%] | 3,05 | 4,11 | 3,09 | 3,09 |

| | | | | |
|---|---|---|---|---|
| **nicht ermittelt | | | | |
| ⁵Die Glasübergangstemperaturen der Laminatproben wurden mit Hilfe von Differential Scanning Calorimetry ermittelt. Tg 1 gibt den sich aus der ersten Messung ergebenden Wert für die Glasübergangstemperatur an, während Tg 2 den Wert angibt, den man erhält, wenn man die Probe nach der ersten Messung noch einmal einer entsprechenden Messung unterzieht. | | | | |
| ⁶N-Methylpyrrolidonaufnahme einer 5 x 5 cm-Laminatprobe bei 23 °C nach 30 Minuten. Die Dicke der Probe entspricht der Dicke des erhaltenen Laminats von ca. 1,6 mm. | | | | |
| ⁷nach 1 Stunde Pressure cooker test (Pct), wobei eine 5 x 5 cm-Laminatprobe 1 Stunde lang im Dampfdrucktopf mit überhitztem Dampf behandelt wird (123°C; 1,2 bar Überdruck). | | | | |
| ⁸Der Pressure cooker test gilt als bestanden (bst), wenn sich bei mindestens 2 von insgesamt 3 Proben, die nach der Entnahme aus dem Dampfdrucktopf jeweils wieder auf Raumtemperatur abgekühlt werden (30 Minuten) und in ein 260 °C heisses Lötbad gehalten werden, keine Blasen bilden. | | | | |
| ⁹gemäss Norm von Underwriters Laboratories Inc. UL 94, Vertikale Brennbarkeitsprüfung, Probendicke 1,6 mm). | | | | |

Beispiel 4: 100 g eines Polyglycidylethers auf Basis eines Phenolformaldehydnovolaks (Epoxidzahl 5,5 - 5,7 Äquiv./kg) und 132 g der Verbindung aus Beispiel 1 werden unter Wärme in 100 g Methylethylketon gelöst. Danach werden 38,50 g einer 10%-igen Lösung von Dicyandiamid und 40 g Aluminiumoxidtrihydrat zugegeben und die Mischung mittels eines Dispergators homogenisiert. Es folgen die Zugabe von 0,02 g 2-Methylimidazol als Beschleuniger und ein nochmaligen Aufrühren. Mit Hilfe dieser Imprägnierlösung wird analog zu Beispiel 3 ein Laminat (LAM5) hergestellt, das die folgenden Eigenschaften zeigt.

| Eigenschaft | LAM5 | Eigenschaft | LAM5 |
|---|---|---|---|
| Tg 1⁵ [°C] | 131,0 | Pct⁸ | bst |
| Tg 2⁵ [°C] | 129,6 | Flammhemmung⁹ | V-1 |
| | | | |
| NMP-Aufnahme⁶ [%] | 0,15 | Brennzeit [s] | 88 |
| H₂O-Aufnahme⁷[%] | 0,33 | | |

| | | | |
|---|---|---|---|
| ^{5,6,7,8,9} siehe unter Beispiel 3 | | | |

Beispiel 5: Aus den in der folgenden Tabelle jeweils angegebenen Komponenten werden die vorverlängerten Epoxidharze 6 bis 9 hergestellt.

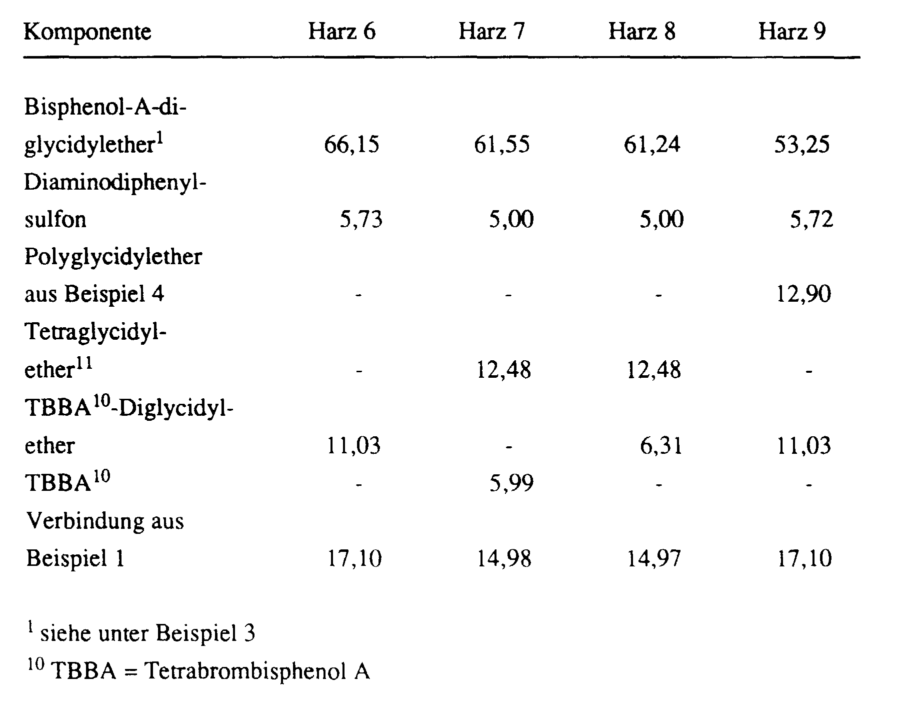

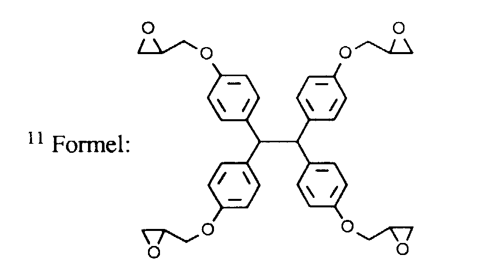

Zur Herstellung vorverlängerten Epoxidharze wird zunächst ein Gemisch aus dem Bisphenol-A-diglycidylether und dem Diaminodiphenylsulfon bei 150 °C 2 Stunden lang abreagieren lassen. Man kühlt auf 130 °C ab, gibt die anderen Komponenten zu und hält das Gemisch noch weitere 1 bis 2 Stunden auf 130 °C. Danach wird das Harz auf ein Aluminiumblech geschüttet und abgekühlt.

Das gepulverte Harz wird mit den sich aus der folgenden Tabelle ergebenden Komponenten zu den Zusammensetzungen Misch6, Misch7, Misch8 und Misch9 vermischt, aufgeschmolzen und homogenisiert.

Diese Harzzusammensetzungen werden zu 1 mm beziehungsweise 2 mm starken Platten vergossen und 1 Stunde lang bei 180 °C ausgehärtet. Die erhaltenen Platten zeigen die in der weiteren Tabelle angeführten Eigenschaften.

| Komponente | Misch6 | Misch7 | Misch8 | Misch9 |
|---|---|---|---|---|
| Harz: Nr. | 6 | 7 | 8 | 9 |
| Menge | 100,00 | 100,00 | 100,00 | 100,00 |
| Polyglycidylether aus Beispiel 4 | 14,29 | - | - | 14,29 |
| Dicyandiamid | 4,57 | 4,00 | 4,00 | 4,57 |
| Weiterer Flammhemmer¹³ | 17,14 | 15,00 | 15,00 | 17,14 |

| | | | | |
|---|---|---|---|---|
| ¹³ (2,6-Dimethylphenyl)2,2'methylenbis(6-tert.-butyl-4-methylphenyl)phosphat (siehe Beispiel 3 der EP-A-0 412 936) | | | | |

| Eigenschaft | Misch6 | Misch7 | Misch8 | Misch9 |
|---|---|---|---|---|
| Tg 1 [°C] | 138 | 135 | 146 | 150 |
| | | | | |
| H₂O-Aufnahme¹⁴ [%] | 0,45 | 0,50 | 0,55 | 0,41 |
| Flammhemmung⁹ | V-0 | V-0 | V-0 | V-0 |
| (1 mm Platte) | | | | |
| Bromgehalt [%] | 3,8 | 3,0 | 2,60 | 3,8 |
| Phosphorgehalt [%] | 1,78 | 1,78 | 1,78 | 1,78 |

| | | | | |
|---|---|---|---|---|
| ¹⁴ 2 mm starke Platte nach 1 Stunde in 100 °C heissem Wasser. | | | | |

Beispiel 6: Glycidylisierung der Verbindung aus Beispiel 1

200 g (0,52 Mol) der Verbindung aus Beispiel 1 werden zusammen mit 92,53 g (1 Mol) Epichlorhydrin in 385 g Methoxypropanol gelöst und auf 70 °C erwärmt. Anschliessend werden 22,88 g (0,572 Mol) NaOH als 80 %-ige Lösung innerhalb von 80 Minuten zugetropft und die Reaktionslösung danach bei 60 bis 65 °C 2 weitere Stunden lang gerührt. Die entstandene Lösung wird mit 20%-iger Natriumhydrogensulfatlösung neutralisiert und zur Trockene eingedampft. Der Rückstand wird in Isobutylmethylketon gelöst, filtriert und das Lösungsmittel im Hochvakuum abgezogen. Man erhält die gewünschte Verbindung in ca. 90%-iger Ausbeute. Sie weist einen Epoxidwert von 1,81 Äquivalenten/kg und einen Phosphorgehalt von 6,82% auf.

Beispiel 7: Wie in Beispiel 3 beschrieben, wird eine ca. 80%-ige Lösung eines vorverlängerten Harzes aus 100 g des dort verwendeten Bisphenol-A-diglycidylethers, 26,5 g der Verbindung aus Beispiel 6, 6,00 g Diaminodiphenylsulfon, 0,01 g 2-Phenylimidazol und 33,13 g Methylethylketon hergestellt.

125 g dieser Lösung werden mit 42,82 g Dicyandiamid (10%-ige Lösung in Methylglycol), 20 g Cyagard®RF 1204, 40 g Apyral 4 und 0,04 g 2-Methylimidazol vermischt. Die Gelierzeit dieser Imprägnierlösung beträgt 295 s bei 170 °C. Wie in Beispiel 3 erläutert wird mit der Imprägnierlösung ein Laminat hergestellt, das folgende Eigenschaften zeigt:

| Eigenschaft | | Eigenschaft | |
|---|---|---|---|
| Tg 1⁵ [°C] | 152,3 | Flammhemmung⁹ | V-1 |
| Tg 2⁵ [°C] | 152,7 | Brennzeit [s] | 68 |
| | | | |
| NMP-Aufnahme⁶[%] | 0,12 | | |

| | | | |
|---|---|---|---|
| ^{5,6,8,9} siehe unter Beispiel 3 | | | |

## Patentansprüche

1. Verbindung der Formel (1) 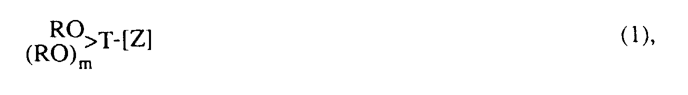 in der
m 0 oder 1 ist,
R ein Wasserstoffatom oder eine Gruppe der Formel 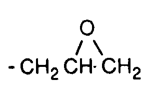 bedeutet,
T entweder eine (m+2)-wertige aromatische Gruppe mit 6 bis 14 Ringkohlenstoffatomen oder eine (m+2)-wertige Gruppe darstellt, die sich durch die Entfernung von (m+2) aromatischen Wasserstoffatomen von einer Verbindung der Formel (2) 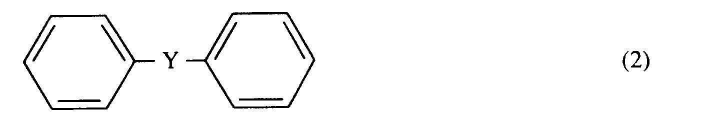 ableitet, in der
Y ein chemisches Strukturelement ausgewählt aus einer Einfachbindung sowie den Gruppen der Formel -O-, -S-, >SO₂, >C=O und 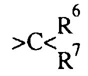 ist, wobei
R⁶ und
R⁷ unabhängig voneinander jeweils ein Wasserstoffatom oder eine Methylgruppe darstellen, und
[Z] eine Gruppe ist, die aus durchschnittlich 1 bis 10 Struktureinheiten ausgewählt aus Struktureinheiten der Formel (3) besteht
-Q-T(OR)₁₊ₘ₋ᵣ(EB)ᵣ (3),
worin
Q eine Gruppe der Formel (4) darstellt 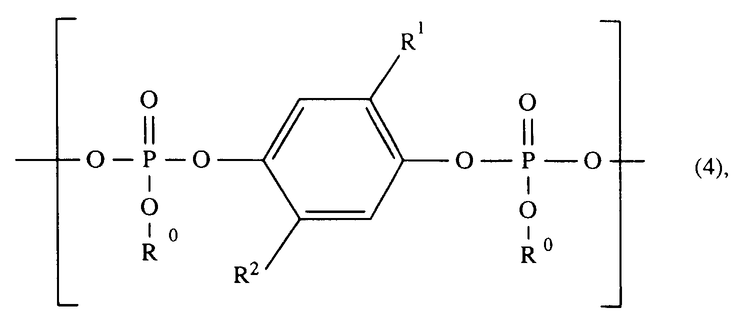 in der
R⁰ einen Rest der Formel (5) 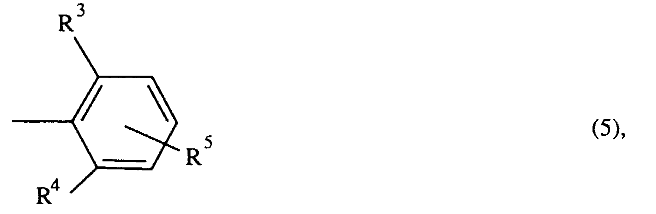
R¹ und
R² und
R³ unabhängig voneinander jeweils eine C₁-C₄-Alkylgruppe,
R⁴ ein Wasserstoffatom oder eine C₁-C₄-Alkylgruppe und
R⁵ ein Wasserstoff-, Brom- oder Chloratom, eine Hydroxylgruppe oder eine Gruppe der Formel 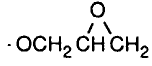 bedeuten,
und in Formel (3) weiterhin
T die gleiche Bedeutung wie in Formel (1) hat,
EB eine freie Valenz der Gruppe T symbolisiert und
r einen der Werte 0, 1 oder 1+m aufweist,
wobei Struktureinheiten der Formel (3) derart und über ihre freien Valenzen zur Gruppe [Z] verknüpft sind, dass sich die Gruppen Q jeweils mit Gruppen T abwechseln und die Gruppe [Z] insgesamt einwertig ist.

2. Verbindung nach Anspruch 1, bei der
m gleich 0 ist.

3. Verbindung nach Anspruch 2, bei der
T ausgewählt ist aus 1,3-Phenylen, 1,4-Phenylen, 1,5-Naphtylen und 2,2'-Bis(4-phenylen)-propan.

4. Verbindung nach Anspruch 1, bei der
m gleich 1 ist.

5. Verbindung nach Anspruch 1, bei der
m gleich 1 ist und
T eine Gruppe der Formel 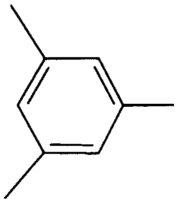 darstellt.

6. Verbindung nach Anspruch 1 bis 5, bei der
[Z] aus 2 bis 5 Strukturelementen der Formel (3) besteht.

7. Verbindung nach Anspruch 1 bis 6, bei der
R⁵ ein Wasserstoffatom, ein Hydroxylgruppe oder eine Gruppe der Formel 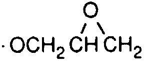 darstellt.

8. Verbindung nach Anspruch 7, bei der R⁵ ein Wasserstoffatom darstellt.

9. Vorverlängertes Epoxidharz, erhältlich durch Umsetzung eines Gemisches, das mindestens eine Verbindung der Formel (1) gemäss Anspruch 1 bis 8, die freie Hydroxylgruppen aufweist, und mindestens eine Polyepoxidverbindung enthält.

10. Zusammensetzung, die eine Verbindung gemäss Anspruch 1 bis 8 zusammen mit einem Epoxidharz oder die ein vorverlängertes Epoxidharz gemäss Anspruch 9 enthält.

11. Zusammensetzung nach Anspruch 10 enthaltend ein vorverlängertes Epoxidharz gemäss Anspruch 9, ein weiteres phosphorhaltiges Flammschutzmittel und gegebenenfalls einen wasserunlöslichen, nicht hygroskopischen und gegenüber dem Harz inerten Füllstoff.

12. Zusammensetzung nach Anspruch 11, die als weiteres phosphorhaltiges Flammschutzmittel die Verbindung der Formel 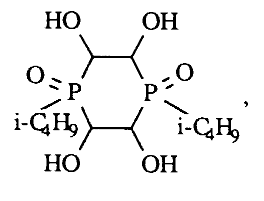 enthält.

13. Zusammensetzung nach Anspruch 12, die zusätzlich Aluminiumoxidtrihydrat enthält.

14. Verwendung einer Zusammensetzung nach Anspruch 10 bis 13 als Laminierharz zur Herstellung des Basislaminatmaterials gedruckter Schaltungen.

## Claims

1. A compound of the formula (1) 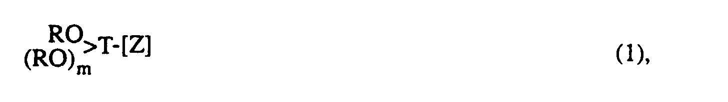 in which
m is 0 or 1,
R is a hydrogen atom or a group of the formula 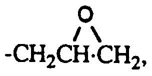
T is either an (m+2)-valent aromatic group having 6 to 14 ring carbon atoms or an (m+2)-valent group which is derived, by removal of (m+2) aromatic hydrogen atoms, from a compound of the formula (2) 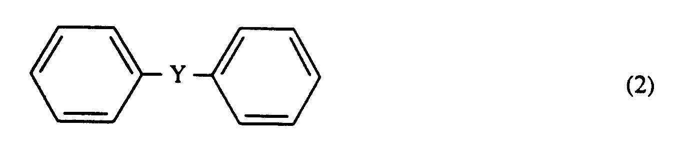 in which
Y is a chemical structural element chosen from a single bond and the groups of the formula -O, -S-, >SO₂, >C=O and 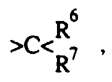 in which
R⁶ and
R⁷ independently of one another in each case are a hydrogen atom or a methyl group, and
[Z] is a group which comprises on average 1 to 10 structural units which are chosen from structural units of the formula (3)
-Q-T(OR)₁₊ₘ₋ᵣ(EB)ᵣ (3),
in which
Q is a group of the formula (4) 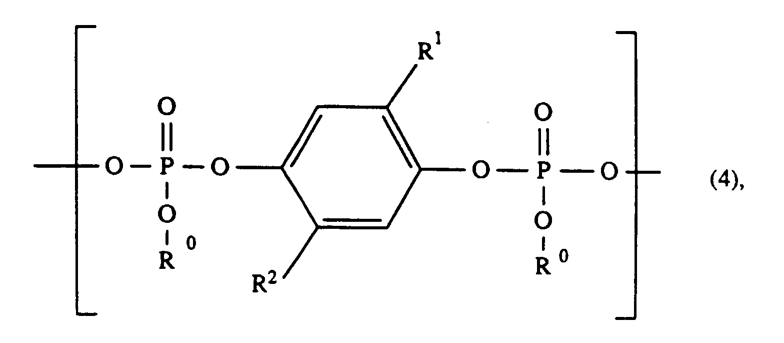 in which
R⁰ is a radical of the formula (5) 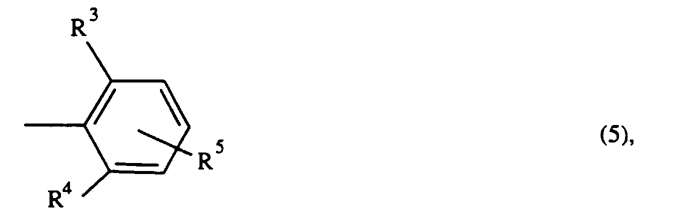
R¹ and
R² and
R³ independently of one another in each case are a C₁-C₄alkyl group,
R⁴ is a hydrogen atom or a C₁-C₄alkyl group and
R⁵ is a hydrogen, bromine or chlorine atom, a hydroxyl group or a group of the formula 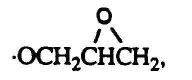 and in formula (3) furthermore
T has the same meaning as in formula (1),
EB symbolizes a free valency of the group T and
r has one of the values 0, 1 or 1+m,
in which structural units of the formula (3) are linked via their free valencies to the group [Z] such that the groups Q in each case alternate with groups T and the group [Z] overall is monovalent.

2. A compound according to claim 1, in which
m is 0.

3. A compound according to claim 2, in which
T is chosen from 1,3-phenylene, 1,4-phenylene, 1,5-naphthylene and 2,2'-bis(4-phenylene)-propane.

4. A compound according to claim 1, in which
m is 1.

5. A compound according to claim 1, in which
m is 1 and
T is a group of the formula

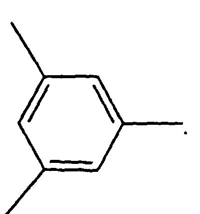

6. A compound according to claim 1 to 5, in which
[Z] is composed of 2 to 5 structural elements of the formula (3).

7. A compound according to claim 1 to 6, in which
R⁵ is a hydrogen atom, a hydroxyl group or a group of the formula

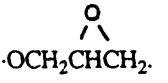

8. A compound according to claim 7, in which R⁵ is a hydrogen atom.

9. A prelengthened epoxy resin obtainable by reaction of a mixture which comprises at least one compound of the formula (1) according to claim 1 to 8 which has free hydroxyl groups and at least one polyepoxy compound.

10. A composition which comprises a compound as claimed in claim 1 to 8 together with an epoxy resin or which comprises a prelengthened epoxy resin according to claim 9.

11. A composition according to claim 10 comprising a prelengthened epoxy resin according to claim 9, another phosphorus-containing flameproofing agent and, if appropriate, a water-insoluble, non-hygroscopic filler which is inert towards the resin.

12. A composition according to claim 11, which comprises the compound of the formula 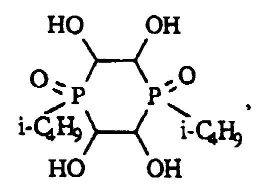 as another phosphorus-containing flameproofing agent.

13. A composition according to claim 12 which additionally comprises aluminium oxide trihydrate.

14. The use of a composition according to claim 10 to 13 as a laminating resin for the production of the base laminate material of printed circuits.

## Revendications

1. Composé de formule 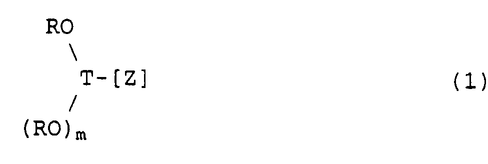 dans laquelle
m vaut 0 ou 1,
R représente un atome d'hydrogène ou un groupe de formule 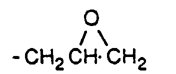
T représente soit un groupe aromatique à fonctionnalité (m+2) avec 6 à 14 atomes de carbone, soit un groupe à fonctionnalité (m+2), lequel, par élimination de (m+2) atomes d'hydrogène aromatiques, dérive d'un composé de formule (2) 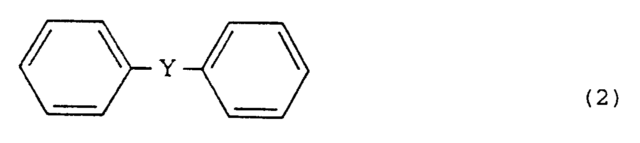 dans laquelle
Y est un élément de structure chimique, pris parmi une liaison simple, ainsi que les groupes de formule -O-, -S-, >SO₂, >C=O et 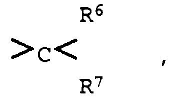
R⁶ et
R⁷ indépendamment l'un de l'autre, chacun représente un atome d'hydrogène ou un groupe méthyle, et
[Z] est un groupe qui est constitué de 1 à 10 unités de structure en moyenne prises parmi les unités de structure de formule (3)
-Q-T(OR)₁₊ₘ₋ᵣ(EB)ᵣ (3),
dans laquelle
Q représente un groupe de formule (4) 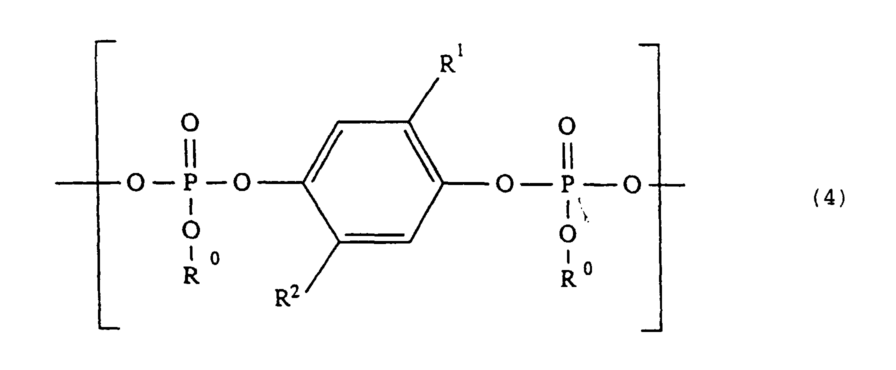 dans laquelle
R⁰ représente un reste de formule (5) 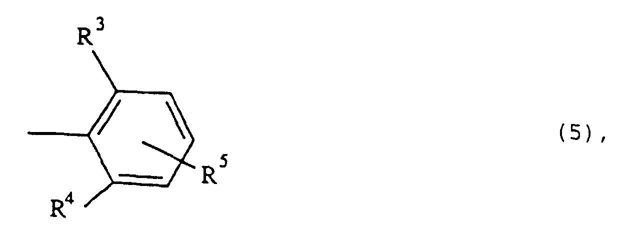
R¹ et
R² et
R³ indépendamment l'un de l'autre, chacun représente un groupe alkyle en C₁-C₄,
R⁴ représente un atome d'hydrogène ou un groupe alkyle en C₁-C₄,
R⁵ représente un atome d'hydrogène, de brome ou de chlore, un groupe hydroxyle ou un groupe de formule 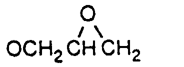 et dans la formule (3)
T possède la signification déjà donnée ci-dessus,
EB symbolise une valence libre du groupe T et
r présente l'une des valeurs 0, 1 ou 1+m,
les unités de structure de formule (3) étant attachées de façon telle et par l'intermédiaire de leurs valences libres au groupe [Z], que les groupes Q se trouvent en alternance avec les groupes T et le groupe [Z] est monovalent dans l'ensemble.

2. Composé selon la revendication 1, dans lequel
m est égal à 0.

3. Composé selon la revendication 2, dans lequel
T est pris parmi le 1,3-phénylène, 1,4-phénylène, 1,5-naphtylène et 2,2'-bis(4-phénylène)propane.

4. Composé selon la revendication 1, dans lequel
m est égal à 1.

5. Composé selon la revendication 1, dans lequel
m est égal à 1 et
T est un groupe de formule

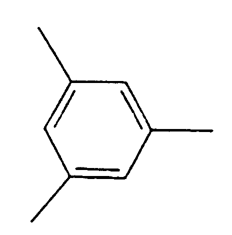

6. Composé selon la revendication 1 à 5, dans lequel
[Z] est constitué de 2 à 5 éléments de structure de formule (3).

7. Composé selon la revendication 1 à 6, dans lequel
R⁵ représente un atome d'hydrogène, un groupe hydroxyle ou un groupe de formule

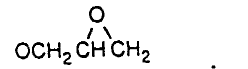

8. Composé selon la revendication 7, dans lequel R⁵ représente un atome d'hydrogène.

9. Résine époxyde pré-allongée que l'on peut obtenir par réaction d'un mélange contenant au moins un composé de formule (1) selon la revendication 1 à 8, qui présente des groupes hydroxyle libres, et au moins un composé polyépoxydé.

10. Composition qui contient un composé selon la revendication 1 à 8, avec une résine époxyde ou qui contient une résine époxyde pré-allongée selon la revendication 9.

11. Composition selon la revendication 10 contenant une résine époxyde pré-allongée selon la revendication 9, un autre agent ignifugeant phosphoré et éventuellement une charge insoluble dans l'eau, non hygroscopique et inerte vis-à-vis de la résine.

12. Composition selon la revendication 11, qui contient comme autre agent ignifugeant phosphoré le composé de formule

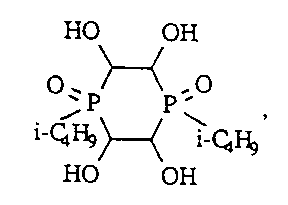

13. Composition selon la revendication 12, qui contient en plus l'oxyde d'aluminium trihydraté.

14. Utilisation d'une composition selon la revendication 10 à 13 comme résine de stratification pour la préparation de matière de base stratifiée pour des circuits imprimés.
